# EUROPEAN PATENT APPLICATION

(11) **EP 2 851 819 A1**
(43) Date of publication of application: **25.03.2015**
(21) Application number: 14185356.4
(22) Date of filing: 18.09.2014
(51) Int. Cl.: G06F 17/50

(54) **Boundary layer computations on CFD grids**

(30) Priority: 20.09.2013 IN CH42302013
(71) Applicant: Airbus India Operations PVT Ltd, 560048 Bangalore (IN)
(72) Inventor: Mangat, Vikram Singh, 560048 BANGALORE (IN); Pandey, Animesh, 560048 BANGALORE (IN)
(74) Representative: Ribeiro, James Michael

(57) **Abstract**

System and method for computing boundary layer properties are disclosed. In one embodiment, a first boundary layer cell that is substantially close to a wall of a structure is selected. A recursive function is then launched for each cell adjacent and around the selected first boundary layer cell to determine a cell having a highest dot product with the normal of the first boundary layer cell. The cell having the highest dot product with the first cell is declared as the second boundary layer cell. The declared cell is selected as the second boundary layer cell. The above steps of selecting, launching and declaring are repeated until a desired number of layers in the boundary layer are completed. The boundary layer properties associated with each selected boundary layer is computed using CFD analysis.

## Description

### FIELD OF TECHNOLOGY

Embodiments of the present subject matter generally relate to computational fluid dynamics (CFD), and more particularly, to boundary layer computations on CFD grids.

### BACKGROUND

Typically, CFD analysis requires accurate prediction of the properties of the boundary layer, i.e., the fluid surrounding the wall of a structure. For example, accurate aerodynamic analysis is particularly important when designing aircraft surfaces, such as the surface of a wing or control surface.

Generally, such boundary layer computations require creating a physical model or computer model, so that a simulation of the fluid flow over the boundary layer can be carried out and properties of the simulated fluid flow can be measured. Such measured fluid-flow properties over the boundary layer may be used to predict the characteristics of the wing including lift, drag, boundary-layer velocity and temperature profiles, pressure distribution and the like.

However, creating either a physical model or a computer model and carrying out the simulations may be very time consuming and expensive. Complex CFD simulation modules can be computationally expensive and may require hours or even days to execute using high-performance computer processing hardware.

### SUMMARY

System and method for boundary layer computations on CFD girds are disclosed. According to one aspect of the present subject matter, a first boundary layer cell that is substantially close to a wall is selected. A recursive function is then launched for each cell adjacent and around the selected first boundary layer cell to determine a cell having a highest dot product with the normal of the first boundary layer cell. The cell having the highest dot product with the first cell is declared as the second boundary layer cell. The declared cell is selected as the second boundary layer cell. The above steps of selecting, launching and declaring are repeated until a desired number of layers in the boundary layer are completed. The boundary layer properties associated with each selected boundary layer is computed using CFD analysis.

According to another aspect of the present subject matter, a system including a processor, and memory coupled to the processor and the memory includes a FEA tool having instructions that is configured to select a first boundary layer cell that is substantially close to a wall of a structure. Launch a recursive function for each cell adjacent and around the selected first boundary layer cell to determine a cell having a highest dot product with the normal of the first boundary layer cell. Declares the cell having the highest dot product with the first cell as the second boundary layer cell. Selects the declared cell as the second boundary layer cell. Repeats the above steps of selecting, launching and declaring until a desired number of layers in the boundary layer are completed. Computes the boundary layer properties associated with each selected boundary layer using CFD analysis.

The systems and methods disclosed herein may be implemented in any means for achieving various aspects. Other features will be apparent from the accompanying drawings and from the detailed description that follow.

### BRIEF DESCRIPTION OF THE DRAWINGS

Various embodiments are described herein with reference to the drawings, wherein:
**FIG. 1** shows an exemplary method for boundary layer computations on CFD grids, according to one embodiment;
**FIG. 2** shows another exemplary method for boundary layer computations on CFD grids, according to one embodiment;
**FIGS. 3A - 3D** show sequential application of the recursive algorithm on a 2D triangular grid to determine cells that are normal to a wall structure and into the fluid in the boundary layer, according to one embodiment; and
**FIG. 4** illustrates a block diagram of an example computing system for implementing boundary layer computations on CFD grids, using the processes shown in **FIGS. 1** and **2****,** according to one embodiment.
The drawings described herein are for illustration purposes only and are not intended to limit the scope of the present disclosure in any way.

### DETAILED DESCRIPTION

System and method of boundary layer computations on CFD grids are disclosed. In the following detailed description of the embodiments of the present subject matter, references are made to the accompanying drawings that form a part hereof, and in which are shown by way of illustration specific embodiments in which the present subject matter may be practiced. These embodiments are described in sufficient detail to enable those skilled in the art to practice the present subject matter, and it is to be understood that other embodiments may be utilized and that changes may be made without departing from the scope of the present subject matter. The following detailed description is, therefore, not to be taken in a limiting sense, and the scope of the present subject matter is defined by the appended claims.

Although certain terms are used primarily herein, other terms could be used interchangeably to yield equivalent embodiments and examples. For example, it is well known that equivalent terms in the field of CFD of related fields could be substituted for such terms as "cell", "element", "grid cell" or the like. The terms "mesh" and "grid" are used interchangeably throughout the document.

Example embodiments proposes an amalgamation of algorithms, techniques and rules to overcome the drawbacks associated with creating physical model on a computer model to predict boundary layer properties over the boundary layer. The proposed example algorithm/technique/rules/formulas proposed works for all cell shapes as it relies mostly on nodes and faces rather than the topology of the cells. This algorithm can be used to generate element-node-element connectivity data when element-face-element connectivity data is present.

### Example Processes

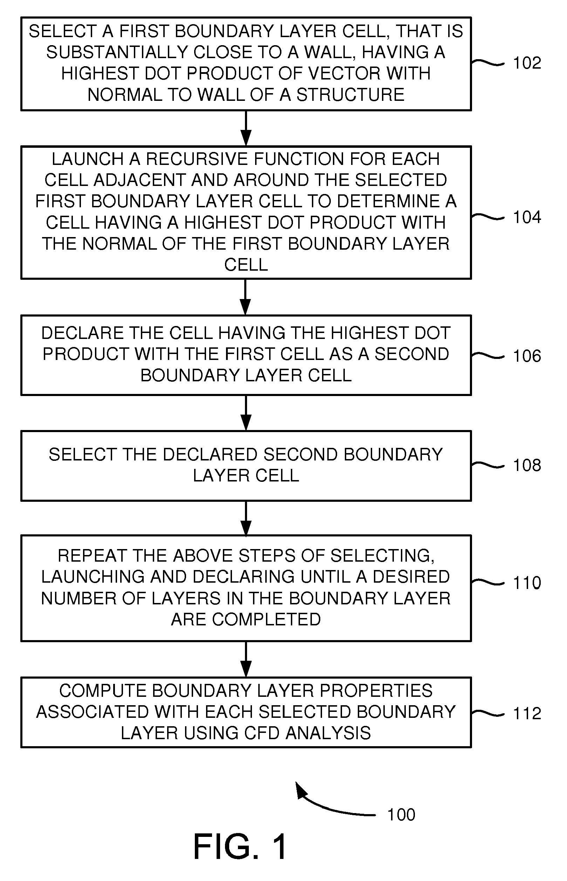

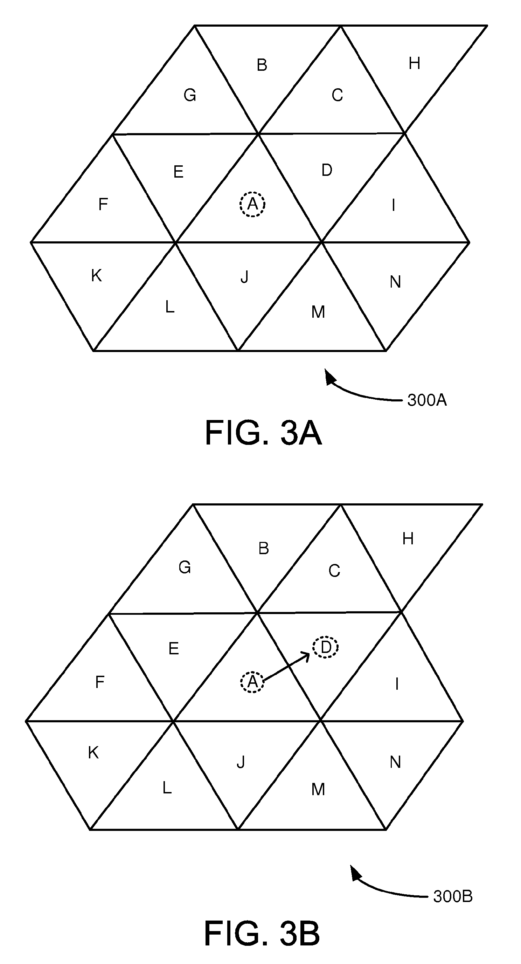

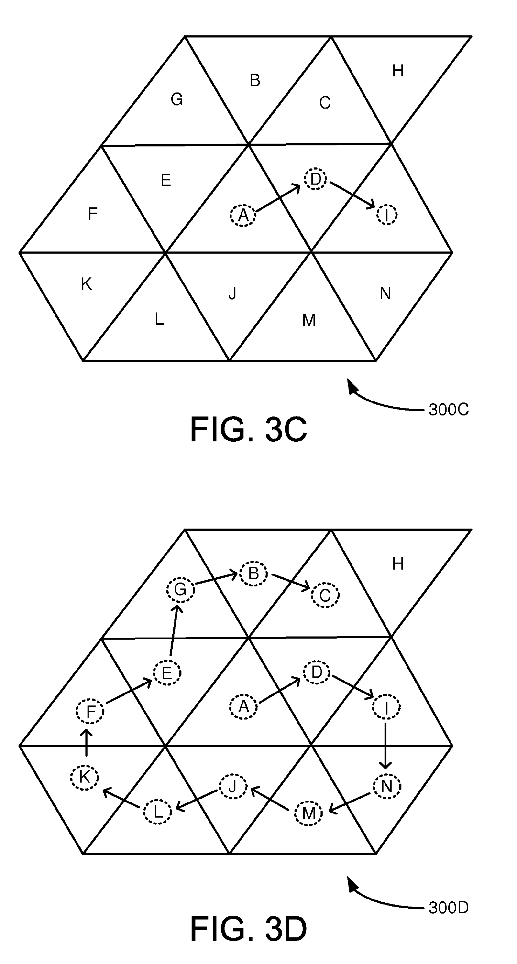

**FIG. 1** illustrates a flowchart 100 for boundary layer properties computation, according to one embodiment. In block 102, a first boundary layer cell that is substantially close to a wall of a structure is selected. For example, cells L, J and M that are close to a wall of a structure shown in CFD mesh 300A in FIG. 3, A may be selected as a first boundary layer cell that is substantially close to the wall having the highest dot product of a vector that is normal to wall of the structure associated with the CFD mesh 300A. In this running example associated with **FIG. 3A****,** cell J is selected as the first boundary layer cell. In some embodiments, the highest dot product of the vector is a product of a vector connecting a cell with another adjacent cell and a vector normal to wall and away from wall or into fluid. Example cell topologies are hexahedral, tetrahedral, prismatic, polyhedral and pyramidal. The cell can be from a 2D or 3D CFD mesh of a structure.

In block 104, a recursive function is launched for each cell that is adjacent to and around the selected first boundary layer cell to determine a cell having a highest dot product with the normal of the first boundary layer cell. In our running example in **FIG. 3A****,** the recursive function is launched from cell A that is adjacent to and around the cell J. In some embodiments, each cell that is adjacent to and around the selected first boundary layer cell is a cell having a common node or face with the selected first boundary layer cell. The **FIGS. 3A, 3B****,** **3C** and **3D** illustrate using 2D meshes, only to facilitate easier understanding of the boundary layer properties computations. However, in practice 3D grids including faces and nodes are used in CFD computations, i.e., boundary layer properties computations.

In some embodiments, a recursive function is launched for each cell that is adjacent to and around the selected first boundary layer cell includes selecting a cell that is adjacent to and having a common face with the first boundary layer cell, because a cell with a common face may have more stored cell connectivity information. In our running example in **FIG. 3A****,** the recursive function is launched from cell A that is adjacent to and around the selected first boundary layer cell J. A determination is then made as to whether the selected cell was previously accessed by the recursive function for computing a dot product. If the selected cell was not previously accessed, then a dot product of a vector connecting the selected cell and the first boundary layer cell with normal is computed. If the selected cell was previously accessed, then applying the recursive function on the selected cell is stopped and a next cell having a common face with the first boundary layer cell is selected. In our running example, this may be cell D shown in **FIG. 3B**.

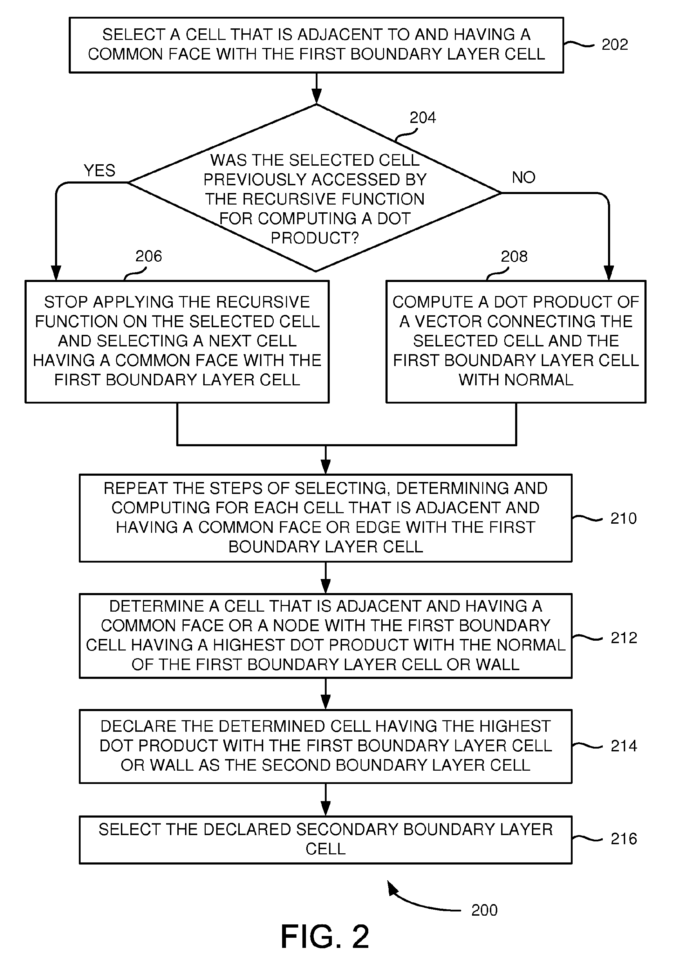

In block 106, the cell having the highest dot product with the first cell as the is declared as the second boundary layer cell. In these embodiments, the steps of selecting, determining and computing are repeated for each cell that is adjacent and having a common face or edge with the first boundary layer cell as show in FIGS. 3A-3D going from cell A to D to I to N to M to J to L to K to F to E to G to B to C and stopping at cell D as it was previously accessed. A cell that is adjacent and having a common face or a node with the first boundary layer cell having a highest dot product of a vector connecting a cell with another adjacent cell and a vector normal to wall and away from wall or into fluid is determined from the computed dot products of the cells that are adjacent and substantially around the first boundary layer cell. The determined cell having the highest dot product with the first boundary layer cell or wall is then declared as the second boundary layer cell. In block 108, the declared secondary boundary layer cell is then selected. This is process is explained in more detail with reference to **FIG. 2** flowchart.

In some embodiments, the inputs to the recursive function are current layer cell index, new cell index and direction to be traversed. In these embodiments, current layer cell index and direction are stored in global variables outside the recursive function. Within the function, following steps may be carried out:
- Cell flag is set to indicate that the boundary layer cell movement is calculated. If the current boundary layer cell movement dot product is higher than previous value, the current boundary layer cell is stored.
- The dot product of direction and current cell movement is calculated. If the current boundary layer cell movement dot product is higher than previous value, the current boundary layer cell is stored.
- Next, a loop over all faces within the new boundary layer cell is carried out. At each face, a check is made of the nodes in the face and nodes of the current boundary layer cell. If there are common nodes, then the boundary layer cell adjacent to the face is accessed. If the adjacent boundary layer cell has been accessed previously in the current boundary layer movement, nothing is done. Otherwise, the recursive function is called on the adjacent boundary layer cell.

In block 110, the above steps of selecting, launching and declaring is repeated until a desired number of layers in the boundary layer are completed. The desired number of layers in the boundary layer may be based on the distance or temperature at some distance from the wall or temperature gradient from wall to a distance away from wall.

In block 112, the boundary layer properties associated with each selected boundary layer is computed using CFD analysis. Example boundary layer properties are temperature, velocity, species and the like.

### Example Computing System Implementation

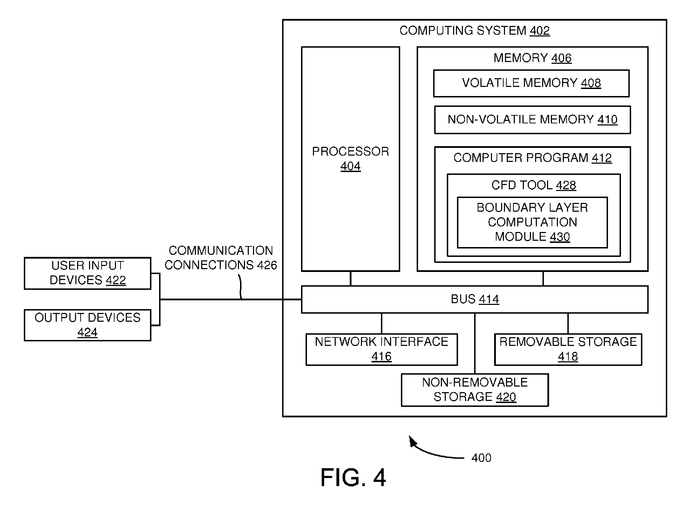

**FIG. 4** illustrates a block diagram 400 of an example computing system 402 for implementing boundary layer computations on CFD grids, using the processes shown in **FIGS. 1** and **2****,** according to one embodiment. **FIG. 4** and the following discussions are intended to provide a brief, general description of a suitable computing environment in which certain embodiments of the inventive concepts contained herein are implemented.

The computing system 402 includes a processor 404, memory 406, a removable storage 418, and a non-removable storage 420. The computing system 402 additionally includes a bus 414 and a network interface 416. As shown in **FIG. 4****,** the computing system 402 includes access to a computing system environment that includes one or more user input devices 422, one or more output devices 424, and one or more communication connections 426 such as a network interface card and/or a universal serial bus connection.

Exemplary user input devices 422 include a digitizer screen, a stylus, a trackball, a keyboard, a keypad, a mouse and the like. Exemplary output devices 424 include a display unit of the personal computer, a mobile device, and the like. Exemplary communication connections 426 include a local area network, a wide area network, and/or other network.

The memory 406 further includes volatile memory 408 and non-volatile memory 410. A variety of computer-readable storage media are stored in and accessed from the memory elements of the computing system 402, such as the volatile memory 408 and the non-volatile memory 410, the removable storage 418 and the non-removable storage 420. The memory elements include any suitable memory device(s) for storing data and machine-readable instructions, such as read only memory, random access memory, erasable programmable read only memory, electrically erasable programmable read only memory, hard drive, removable media drive for handling compact disks, digital video disks, diskettes, magnetic tape cartridges, memory cards, Memory Sticks™, and the like.

The processor 404, as used herein, means any type of computational circuit, such as, but not limited to, a microprocessor, a microcontroller, a complex instruction set computing microprocessor, a reduced instruction set computing microprocessor, a very long instruction word microprocessor, an explicitly parallel instruction computing microprocessor, a graphics processor, a digital signal processor, or any other type of processing circuit. The processor 404 also includes embedded controllers, such as generic or programmable logic devices or arrays, application specific integrated circuits, single-chip computers, smart cards, and the like.

Embodiments of the present subject matter may be implemented in conjunction with program modules, including functions, procedures, data structures, and application programs, for performing tasks, or defining abstract data types or low-level hardware contexts. Machine-readable instructions stored on any of the above-mentioned storage media may be executable by the processor 404 of the computing system 402. For example, a computer program 412 includes machine-readable instructions capable for implementing the boundary layer computations on the CFD grids, according to the teachings and herein described embodiments of the present subject matter. In one embodiment, the computer program 412 is included on a compact disk-read only memory (CD-ROM) and loaded from the CD-ROM to a hard drive in the non-volatile memory 410. The machine-readable instructions cause the computing system 402 to encode according to the various embodiments of the present subject matter.

As shown, the computer program 412 includes a boundary layer computation module 430 within a CFD tool 428. For example, the boundary layer computation module 430 can be in the form of instructions stored on a non-transitory computer-readable storage medium. The non-transitory computer-readable storage medium having the instructions that, when executed by the computing system 402, causes the computing system 402 to perform the methods described in FIGS. 1 and 2.

The above technique works for cells of all shapes as it relies on the nodes and faces of the cells rather than the topology of cell itself. In addition to carrying out the boundary layer calculations, the recursive function can also be used to generate node-element-node connectivity data from face-element-face data.

Although certain methods, systems, apparatus, and articles of manufacture have been described herein, the scope of coverage of this patent is not limited thereto. To the contrary, this patent covers all methods, apparatus, and articles of manufacture fairly falling within the scope of the appended claims either literally or under the doctrine of equivalents.

## Claims

1. A method of computing boundary layer properties, comprising:
selecting a first boundary layer cell, that is substantially close to a wall of a structure;
launching a recursive function for each cell that is adjacent to and around the selected first boundary layer cell to determine a cell having a highest dot product with the normal of the first boundary layer cell;
declaring the cell having the highest dot product with the first cell as the second boundary layer cell;
selecting the declared second boundary layer cell;
repeating the above steps of selecting, launching and declaring until a desired number of layers in the boundary layer are completed; and
computing the boundary layer properties associated with each selected boundary layer using CFD analysis.

2. The method of claim 1, wherein each cell adjacent and around the selected first boundary layer cell comprises:
each cell having a common node or face with the selected first boundary layer cell.

3. The method of claim 1, wherein the highest dot product of the vector comprises a product of a vector connecting a cell with another adjacent cell and a vector normal to wall and away from wall or into fluid.

4. The method of claim 1, wherein launching the recursive function for each cell around the selected first boundary layer cell and either having a common node or face with the selected first boundary layer cell to determine a cell having a highest dot product with the normal of the first boundary layer cell, comprises:
selecting a cell that is adjacent to and having a common face with the first boundary layer cell;
determining whether the selected cell was previously accessed by the recursive function for computing a dot product;
if not, computing a dot product of a vector connecting the selected cell and the first boundary layer cell with normal;
if so, then stopping applying the recursive function on the selected cell and selecting a next cell having a common face with the first boundary layer cell;
repeating the steps of selecting, determining and computing for each cell that is adjacent and having a common face or edge with the first boundary layer cell;
determining a cell that is adjacent and having a common face or a node with the first boundary layer cell having a highest dot product with the normal of the first boundary layer cell or wall;
declaring the determined cell having the highest dot product with the first boundary layer cell or wall as the second boundary layer cell; and
selecting the declared secondary boundary layer cell.

5. The method of claim 1, wherein the desired number of layers in the boundary layer is based on a distance or temperature at some distance from the wall or temperature gradient from wall to a distance away from the wall.

6. A non-transitory computer storage medium having instructions that, when executed by a computing device cause the computing device to:
select a first boundary layer cell, that is substantially close to a wall of a structure;
launch a recursive function for each cell that is adjacent to and around the selected first boundary layer cell to determine a cell having a highest dot product with the normal of the first boundary layer cell;
declare the cell having the highest dot product with the first cell as the second boundary layer cell;
select the declared second boundary layer cell;
repeat the above steps of selecting, launching and declaring until a desired number of layers in the boundary layer are completed; and
compute the boundary layer properties associated with each selected boundary layer using CFD analysis.

7. The non-transitory storage medium of claim 6, wherein each cell adjacent and around the selected first boundary layer cell comprises:
each cell having a common node or face with the selected first boundary layer cell.

8. The non-transitory storage medium of claim 6, wherein the highest dot product of the vector comprises a product of a vector connecting a cell with another adjacent cell and a vector normal to wall and away from wall or into fluid.

9. The non-transitory storage medium of claim 6, wherein launching the recursive function for each cell around the selected first boundary layer cell and either having a common node or face with the selected first boundary layer cell to determine a cell having a highest dot product with the normal of the first boundary layer cell, comprises:
selecting a cell that is adjacent to and having a common face with the first boundary layer cell;
determining whether the selected cell was previously accessed by the recursive function for computing a dot product;
if not, computing a dot product of a vector connecting the selected cell and the first boundary layer cell with normal;
if so, then stopping applying the recursive function on the selected cell and selecting a next cell having a common face with the first boundary layer cell;
repeating the steps of selecting, determining and computing for each cell that is adjacent and having a common face or edge with the first boundary layer cell;
determining a cell that is adjacent and having a common face or a node with the first boundary layer cell having a highest dot product with the normal of the first boundary layer cell or wall;
declaring the determined cell having the highest dot product with the first boundary layer cell or wall as the second boundary layer cell; and
selecting the declared secondary boundary layer cell.

10. The non-transitory storage medium of claim 9, wherein the desired number of layers in the boundary layer is based on a distance or temperature at some distance from the wall or temperature gradient from wall to a distance away from the wall.

11. A system comprising:
a processor; and
a memory coupled to the processor, wherein the memory includes a CFD tool including a boundary layer computation module having instructions configured to:
selecting a first boundary layer cell, that is substantially close to a wall of a structure;
launching a recursive function for each cell that is adjacent to and around the selected first boundary layer cell to determine a cell having a highest dot product with the normal of the first boundary layer cell;
declaring the cell having the highest dot product with the first cell as the second boundary layer cell;
selecting the declared second boundary layer cell;
repeating the above steps of selecting, launching and declaring until a desired number of layers in the boundary layer are completed; and
computing the boundary layer properties associated with each selected boundary layer using CFD analysis.

12. The system of claim 11, wherein each cell adjacent and around the selected first boundary layer cell comprises:
each cell having a common node or face with the selected first boundary layer cell.

13. The system of claim 11, wherein the highest dot product of the vector comprises a product of a vector connecting a cell with another adjacent cell and a vector normal to wall and away from wall or into fluid.

14. The system of claim 11, wherein launching the recursive function for each cell around the selected first boundary layer cell and either having a common node or face with the selected first boundary layer cell to determine a cell having a highest dot product with the normal of the first boundary layer cell by the boundary layer computation module comprises:
selecting a cell that is adjacent to and having a common face with the first boundary layer cell;
determining whether the selected cell was previously accessed by the recursive function for computing a dot product;
if not, computing a dot product of a vector connecting the selected cell and the first boundary layer cell with normal (*to get direction with the vertical*);
if so, then stopping applying the recursive function on the selected cell and selecting a next cell having a common face with the first boundary layer cell;
repeating the steps of selecting, determining and computing for each cell that is adjacent and having a common face or edge with the first boundary layer cell;
determining a cell that is adjacent and having a common face or a node with the first boundary layer cell having a highest dot product with the normal of the first boundary layer cell or wall;
declaring the determined cell having the highest dot product with the first boundary layer cell or wall as the second boundary layer cell; and
selecting the declared secondary boundary layer cell.

15. The system of claim 11, wherein the desired number of layers in the boundary layer is based on a distance or temperature at some distance from the wall or temperature gradient from wall to a distance away from the wall.
